# EUROPEAN PATENT SPECIFICATION

(11) **EP 4 318 929 B1**
(45) Date of publication and mention of the grant of the patent: **26.11.2025**
(21) Application number: 22780629.6
(22) Date of filing: 25.03.2022
(51) Int. Cl.: F28D 7/16, H02N 11/00, F28D 7/10, H10N 10/13

(54) **THERMOELECTRIC POWER GENERATION SYSTEM**
THERMOELEKTRISCHES STROMERZEUGUNGSSYSTEM
SYSTÈME DE GÉNÉRATION D'ÉNERGIE THERMOÉLECTRIQUE

(30) Priority: 01.04.2021 JP 2021062772
(43) Date of publication of application: 07.02.2024
(73) Proprietor: E-ThermoGentek Co. Ltd., Kyoto-shi, Kyoto 601-8047 (JP); KAWASAKI JUKOGYO KABUSHIKI KAISHA, Kobe-shi, Hyogo 650-8670 (JP); Kawasaki Thermal Engineering Co., Ltd., Kasatsu-shi Shiga 525-8558 (JP)
(72) Inventor: UNO, Takashi, Kyoto-shi, Kyoto 601-8047 (JP); MAJIMA, Nao, Kyoto-shi, Kyoto 601-8047 (JP); OKAJIMA, Michio, Kyoto-shi, Kyoto 601-8047 (JP); OHATA, Keiichi, Kyoto-shi, Kyoto 601-8047 (JP); NAMBU, Shutaro, Kyoto-shi, Kyoto 601-8047 (JP); GODA, Makoto, Kobe-shi, Hyogo 650-8670 (JP); NAKAYASU, Minoru, Kobe-shi, Hyogo 650-8670 (JP); KANEDA, Yoma, Kobe-shi, Hyogo 650-8670 (JP); SAKAGUCHI, Masamichi, Tokyo 105-8315 (JP); YANAGIDA, Takahide, Kusatsu-shi, Shiga 525-8558 (JP); MAEDA, Yusei, Kusatsu-shi, Shiga 525-8558 (JP)
(74) Representative: advotec.
(86) International application number: PCT/JP2022/014644
(87) International publication number: WO 2022/210416

(56) References cited:
- CN-A- 105 992 927
- JP-A- 2013 165 240
- JP-A- 2014 127 617
- JP-A- 2015 166 555
- JP-A- 2019 047 565
- JP-B2- 6 237 345
- JP-U- S59 161 662
- US-A1- 2011 258 995
- US-A1- 2012 324 909
- US-B2- 9 003 784
- US-B2- 9 306 143

## Description

### TECHNICAL FIELD

The present invention relates to a thermoelectric power generation system using a shell-and-tube heat exchanger.

### BACKGROUND ART

In a current industrial society, mainly in a factory, an electric power plant, a steel plant, an automobile, a building, an illumination, a ship, etc., an enormous waste heat amount of 60% or more of the total primary energy supply amount has been discharged to global environment. It has been assumed that 75% or more of such waste heat is drainage water or exhaust gas at 250°C or lower. Such waste heat, e.g., drainage steam from a steam turbine, is recovered by a shell-and-tube heat exchanger. The drainage steam introduced into a shell (drum container) exchanges heat with, e.g., cold water flowing in a tube inserted into the shell. A thermoelectric power generation system according to the preamble of claim 1, using double tubes in a shell-and-tube heat exchanger with thermoelectric power generation modules inserted between the inner tubes and the outer tubes is disclosed in US 2012/324909 A1.

### SUMMARY OF THE INVENTION

### TECHNICAL PROBLEM

However, in a conventional shell-and-tube heat exchanger, drainage steam introduced into a shell can be cooled, but it is difficult to use hot water subjected to heat exchange in a tube. For this reason, recovered thermal energy is wasted, leading to a problem on energy saving.

The present invention has been made in view of the above-described point, and a main object thereof is to provide a thermoelectric power generation system capable of producing easy-to-use electric energy from waste heat energy and effectively using the waste heat energy.

### SOLUTION TO THE PROBLEM

A thermoelectric power generation system according to the present invention includes a shell-and-tube heat exchanger configured such that a tube including double tubes of an inner tube and an outer tube is inserted into a shell, and a thermoelectric power generation module inserted into between the inner tube and the outer tube. The thermoelectric power generation module generates thermoelectric power using a temperature difference between a first medium flowing in the inner tube and a second medium flowing outside the outer tube in the shell.

In a preferred embodiment, the second medium flowing in the shell is drainage hot water and drainage steam in geothermal power generation, continuous blow hot drainage water from a boiler, flash steam from a boiler, drainage steam from a steam turbine, or drainage hot water or drainage steam from a gas engine.

According to the invention, the tube includes a plurality of tubes inserted into the shell. An inner tube of each tube is fixed to the shell with an inner-tube fixing tube plate, and an outer tube of each tube is fixed to the shell with an outer-tube fixing tube plate. The output of the thermoelectric power generation module is taken out through a clearance between the inner-tube fixing tube plate and the outer-tube fixing tube plate.

### ADVANTAGES OF THE INVENTION

According to the present invention, a thermoelectric power generation system can be provided, which is capable of recovering thermal energy, which has not been recovered so far, by thermoelectric power generation to produce easy-to-use electric energy from waste heat energy and effectively use the waste heat energy.

### BRIEF DESCRIPTION OF THE DRAWINGS

[FIG. 1] FIG. 1 is a view schematically showing the configuration of a thermoelectric power generation system including a shell-and-tube heat exchanger according to one embodiment of the present invention.
[FIG. 2] FIG. 2 is a sectional view along an A-A line of FIG. 1.
[FIG. 3] FIG. 3 is a view showing a specific configuration of a thermoelectric power generation module in the present invention.
[FIG. 4] FIG. 4 is a view showing a method for fixing an inner tube and an outer tube of a tube and taking out the output of the thermoelectric power generation module in the shell-and-tube heat exchanger.
[FIG. 5] FIG. 5 is a view showing the configuration of a thermoelectric power generation system including shell-and-tube heat exchangers having a thermoelectric power generation function in another embodiment of the present invention.
[FIG. 6] FIG. 6 is a view showing the configuration of a thermoelectric power generation system including a shell-and-tube heat exchanger having a thermoelectric power generation function in still another embodiment of the present invention.
[FIG. 7] FIG. 7 is a view showing the configuration of a thermoelectric power generation system including a shell-and-tube heat exchanger having a thermoelectric power generation function in still another embodiment of the present invention.
[FIG. 8] FIG. 8 is a view showing the configuration of a thermoelectric power generation system including a shell-and-tube heat exchanger having a thermoelectric power generation function in still another embodiment of the present invention.
[FIG. 9] FIG. 9 is a view showing the configuration of a thermoelectric power generation system including a shell-and-tube heat exchanger having a thermoelectric power generation function in still another embodiment of the present invention.

### DESCRIPTION OF EMBODIMENTS

Hereinafter, an embodiment of the present invention will be described in detail based on the drawings. Note that the present invention is not limited to the following embodiment. Moreover, changes can be made as necessary without departing from a scope in which advantageous effects of the present invention can be provided.

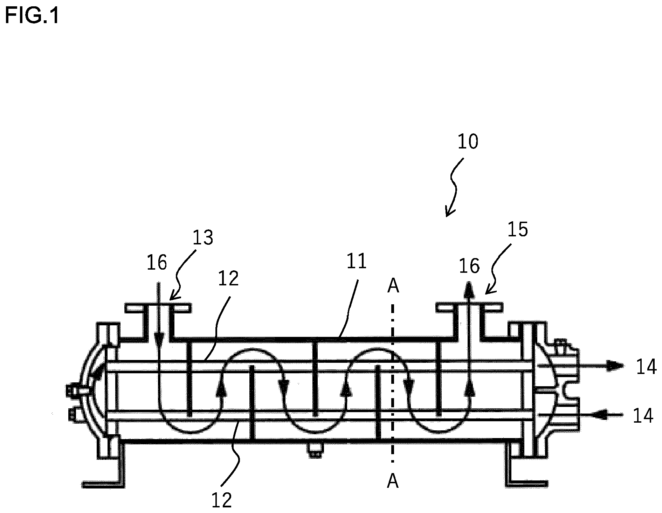

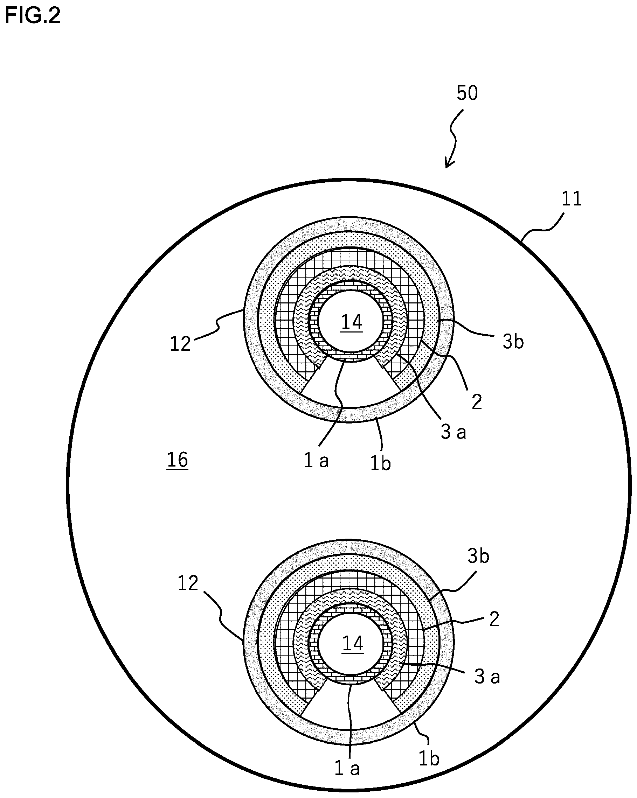

FIGS. 1 and 2 are views schematically showing the configuration of a thermoelectric power generation system 10 including a shell-and-tube heat exchanger 50 according to one embodiment of the present invention. FIG. 2 is a sectional view along an A-A line of FIG. 1.

As shown in FIGS. 1 and 2, tubes 12 (two in the figure) are inserted into a shell (drum container) 11 of the heat exchanger 50. Fluid (first medium) 16 such as excess water vapor flows into the shell 11 through an inlet 13, flows between the inside of the shell 11 and the outside of the tubes 12, and flows out through an outlet 15. Coolant (second medium) 14 such as water is injected into the tube 12 front one end thereof, and exchanges heat with the fluid 16 such as excess water vapor. Accordingly, the fluid 16 is cooled, and the coolant 14 itself is warmed.

As shown in FIG. 2, the tube 12 inserted into the shell 11 of the heat exchanger 50 includes double tubes of an inner tube 1a and an outer tube 1b, and a thermoelectric power generation module 2 is attached to the outer surface of the inner tube 1a preferably through a heat dissipation sheet 3a. Moreover, a heat dissipation sheet 3b is mounted between the thermoelectric power generation module 2 and the outer tube 1b. The coolant 14 flows in the inner tube 1a.

Sheets with a high thermal conductivity are preferably used as the heat dissipation sheets 3a, 3b inserted between the inner tube 1a and the thermoelectric power generation module 2 and between the thermoelectric power generation module 2 and the outer tube 1b. With this configuration, adhesion between the thermoelectric power generation module 2 and each of the inner tube 1a and the outer tube 1b can be ensured, and a heat transfer loss can be reduced. As a result, a great temperature difference in the thermoelectric power generation module 2 can be ensured, and a thermoelectric power generation efficiency can be improved.

The double tubes sandwiching the thermoelectric power generation module 2 may be produced in such a manner that the thermoelectric power generation module is wound around the inner tube 1a through the heat dissipation sheet 3a, e.g., a silicone rubber sheet having a thermal conductivity of 4 W/mK and a thickness of 1 mm, the heat dissipation sheet 3b is attached thereto, and the outer tube 1b is fitted thereon.

If a carbon sheet having a thermal conductivity of 30 W/mK is used as the heat dissipation sheet 3b, heat transfer and slipperiness can be improved, and therefore, the outer tube 1b can be easily fitted onto the heat dissipation sheet 3b. If seamless tubes, i.e., tubes with no joints, are used as the inner tube 1a and the outer tube 1b, a highly-reliable system having excellent pressure resistance and causing no leakage can be built.

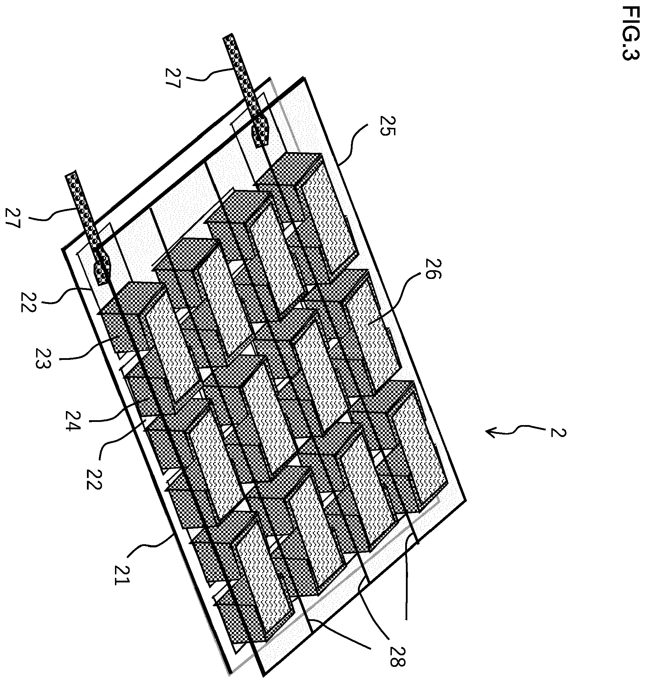

FIG. 3 is a view showing a specific configuration of the thermoelectric power generation module 2. As shown in FIG. 3, P-type thermoelectric devices 23 and N-type thermoelectric devices 24 are alternately arrayed and mounted on wiring lands 22 formed on a flexible base substrate 21. The P-type thermoelectric device 23 and the N-type thermoelectric device 24 are connected in series through a wiring layer 26 formed on a flexible upper wiring board 25. Generated thermoelectric power is taken out through lead-out electrodes 27.

The upper wiring board 25 is formed with slits 28, each of which is formed between adjacent ones of the lines of the P-type thermoelectric devices 23 and the N-type thermoelectric devices 24 connected to each other. With this configuration, the module 2 is easily bendable in a direction at a right angle to the slit 28, and by aligning the slits 28 with a tube axis direction, the module 2 can easily closely contact the inner tube 1a. Note that in this figure, the flexible upper wiring board 25 is seen through for the sake of illustration of the state of lower chip mounting and wiring.

The thermoelectric power generation system 10 in the present embodiment is configured, for example, such that the inner tube 1a has an outer diameter of 25.4 mm, the thermoelectric power generation module 2 has a size of 10 cm square and a thickness of 1.2 mm, and the outer tube 1b has an outer diameter of 36 mm.

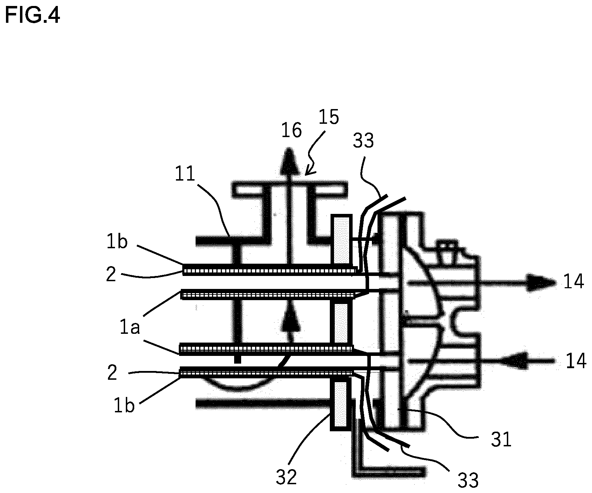

FIG. 4 is a view showing a method for fixing the inner tube 1a and the outer tube 1b of the tube 12 and taking out the output of the thermoelectric power generation module 2 in the shell-and-tube heat exchanger 50.

As shown in FIG. 4, the inner tube 1a of the tube 12 is fixed to the shell 11 with an inner-tube fixing tube plate 31, and the outer tube 1b is fixed to the shell 11 with an outer-tube fixing tube plate 32. The output 33 of the thermoelectric power generation module 2 is taken out through a clearance between the inner-tube fixing tube plate 31 and the outer-tube fixing tube plate 32.

### (Other Embodiments)

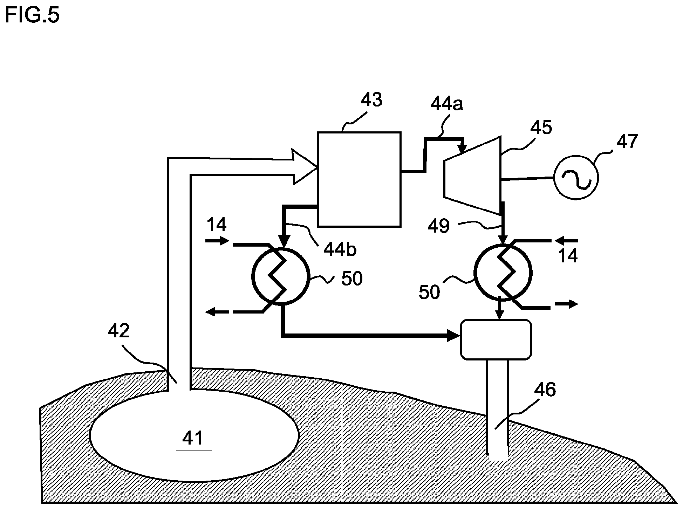

FIG. 5 is a view showing the configuration of a thermoelectric power generation system including the shell-and-tube heat exchangers 50 having a thermoelectric power generation function using drainage hot water and drainage steam in geothermal power generation.

In geothermal power generation, a geothermal spring source 41 is pumped up from a production well 42, and is separated into steam 44a and hot water 44b in a steam-water separator 43. The steam 44a is introduced into a steam turbine 45, and generates power by rotating the turbine 45 and a power generator 47.

In normal geothermal power generation, drainage steam 49 from the steam turbine 45 is returned to water by a condenser, and together with the hot water 44b, is returned to the ground through a return well 46 in order to avoid depletion of the spring source. Thermal energy is wastefully discarded.

However, in the thermoelectric power generation system of the present embodiment, the hot water 44b and the drainage steam 49 are introduced into the thermoelectric power generation function-equipped shell-and-tube heat exchangers 50 shown in FIG. 2 to exchange heat with the coolant 14 and to generate thermoelectric power by the thermoelectric power generation modules (not shown) shown in FIG. 2, as shown in FIG. 5. Thus, waste energy can be effectively used.

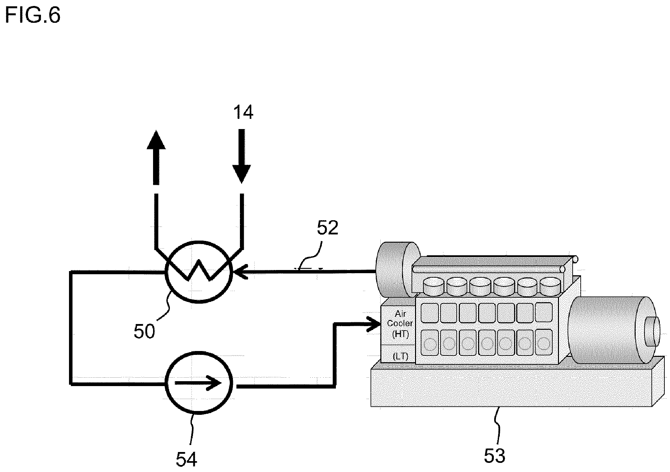

FIG. 6 is a view showing the configuration of a thermoelectric power generation system including the shell-and-tube heat exchanger 50 having a thermoelectric power generation function using hot drainage water from a gas engine.

Hot drainage water 52 from a gas engine 53 is introduced into the thermoelectric power generation function-equipped shell-and-tube heat exchanger 50 shown in FIG. 2, is cooled by exchanging heat with the coolant 14, and is returned to the gas engine 53 by a pump 54. In addition, thermoelectric power is generated by the thermoelectric power generation module (not shown) shown in FIG. 2. Thus, waste energy can be effectively used.

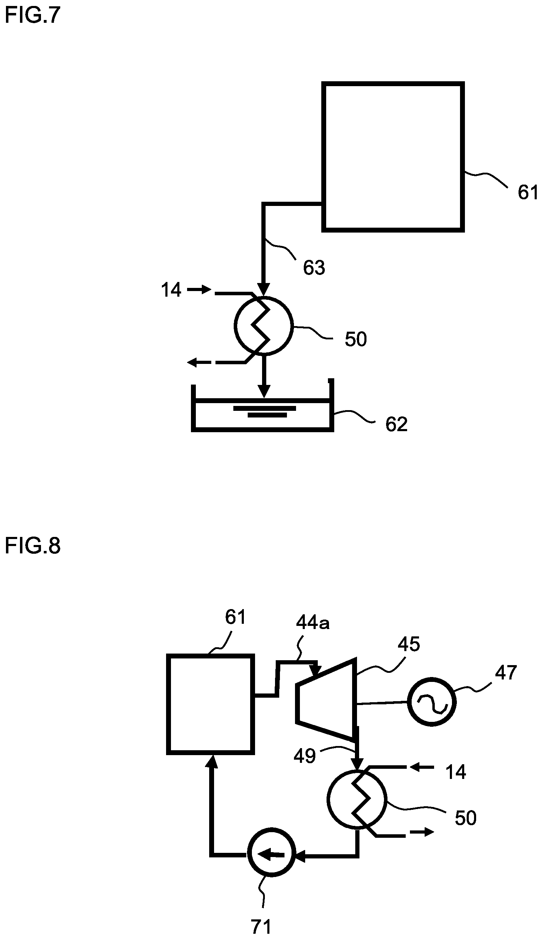

FIG. 7 is a view showing the configuration of a thermoelectric power generation system including the shell-and-tube heat exchanger 50 having a thermoelectric power generation function using continuous blow hot drainage water from a boiler.

In order to prevent, e.g., impurity accumulation, maintenance is regularly performed for a boiler 61 to discharge continuous blow hot drainage water 63. The continuous blow hot drainage water 63 is introduced into the thermoelectric power generation function-equipped shell-and-tube heat exchanger 50 shown in FIG. 2, is cooled by exchanging heat with the coolant 14, and is discharged to a drainage tank 62. In addition, thermoelectric power is generated by the thermoelectric power generation module (not shown) shown in FIG. 2. Thus, waste energy can be effectively used.

FIG. 8 is a view showing the configuration of a thermoelectric power generation system including the shell-and-tube heat exchanger 50 having a thermoelectric power generation function using drainage steam from a steam turbine.

A boiler 61 generates steam 44a to drive a steam turbine 45, and accordingly, a power generator 47 rotates to generate power. Drainage steam 49 from the steam turbine 45 is introduced into the thermoelectric power generation function-equipped shell-and-tube heat exchanger 50 shown in FIG. 2, is cooled by exchanging heat with the coolant 14, and is returned to water, i.e., is condensed. The condensate is returned to the boiler 61 by a water supply pump 71. As described above, the heat exchanger 50 operates as a condenser, and thermoelectric power is generated by the thermoelectric power generation module (not shown) shown in FIG. 2. Thus, waste energy can be effectively used.

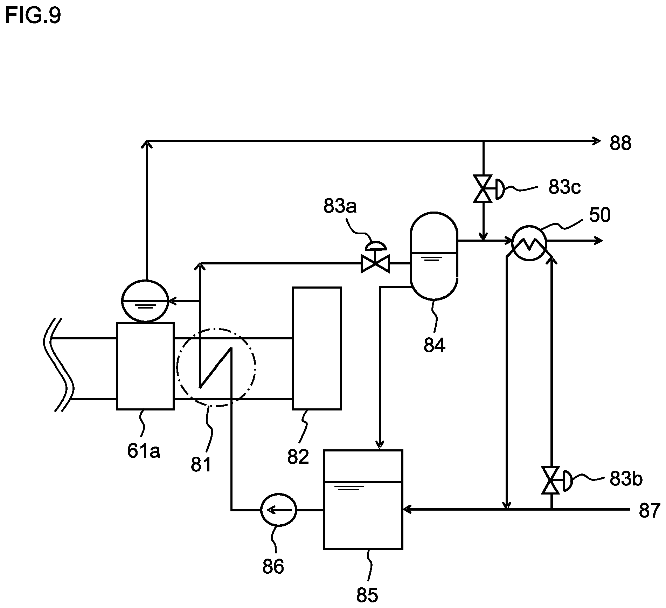

FIG. 9 is a view showing the configuration of a thermoelectric power generation system including the shell-and-tube heat exchanger 50 having a thermoelectric power generation function using flash steam from a boiler.

An exhaust heat boiler 61a generates steam 88 to be used in a process. Raw water 87 stored in a water tank 85 is supplied to the exhaust heat boiler 61a by a water supply pump 86, and is preliminarily heated with exhaust heat discharged to an exhaust pipe 82 in an economizer 81. Part of the raw water 87 is sent to a flash tank 84, and generates hot water and flash steam.

The flash steam is introduced into the thermoelectric power generation function-equipped shell-and-tube heat exchanger 50 shown in FIG. 2, is cooled by exchanging heat with the coolant, is returned to water, and is returned to the water tank 85. Moreover, the coolant is warmed using the raw water 87 in the heat exchanger 50. Thus, the thermoelectric power generation module (not shown) shown in FIG. 2 generates thermoelectric power using a temperature difference between the steam and the raw water, and waste energy in this system can be effectively used.

Valves 83a, 83b, 83c in the middle of the system are for adjusting a steam amount and a thermoelectric power generation amount in the system according to steam and power demands. For example, in the case of a great power demand and a small steam demand, the valves 83a, 83b are opened to increase the thermoelectric power generation amount. In the case of a small power demand and a great steam demand, the valves 83a, 83b are closed to increase the steam amount. In the case of a great power demand and an extremely-small steam demand, the valves 83a, 83b, 83c are opened to increase the thermoelectric power generation amount. As described above, variable thermoelectric power generation operation is allowed by opening/closing of the valves 83a, 83b, 83c.

The present invention has been described above with reference to the preferred embodiments, but is not limited to description of these embodiments. Needless to say, various modifications can be made within the scope of the appended claims.

### DESCRIPTION OF REFERENCE CHARACTERS

- 1a: Inner Tube
- 1b: Outer Tube
- 2: Thermoelectric Power Generation Module
- 3a, 3b: Heat Dissipation Sheet
- 10: Thermoelectric Power Generation System
- 11: Shell
- 12: Tube
- 13: Inlet of Shell-Side Fluid
- 14: Coolant (First Medium)
- 15: Outlet of Shell-Side Fluid
- 16: Fluid (Second Medium)
- 21: Base Substrate
- 22: Wiring Land
- 23: P-Type Thermoelectric Device
- 24: N-Type Thermoelectric Device
- 25: Upper Wiring Board
- 26: Wiring Layer
- 27: Electrode
- 28: Slit
- 31: Inner-Tube Fixing Tube Plate
- 32: Outer-Tube Fixing Tube Plate
- 33: Output of Thermoelectric Power Generation Module
- 41: Geothermal Spring Source
- 42: Production Well
- 43: Steam-Water Separator
- 44a: Steam
- 44b: Hot Water
- 45: Steam Turbine
- 46: Return Well
- 47: Power Generator
- 48: Condenser
- 49: Drainage Steam
- 50: (Thermoelectric Power Generation Function-Equipped) Shell-and-Tube Heat Exchanger
- 52: Hot Drainage Water
- 53: Gas Engine
- 54: Pump
- 61: Boiler
- 61a: Exhaust Heat Boiler
- 62: Drainage Tank
- 63: Continuous Blow Hot Drainage Water
- 71, 86: Water Supply Pump
- 81: Economizer
- 82: Exhaust Pipe
- 83a, 83b, 83c: Valve
- 84: Flash Tank
- 85: Water Tank
- 87: Raw Water
- 88: Process Steam

## Claims

1. A thermoelectric power generation system comprising:
a shell-and-tube heat exchanger (50) configured such that a tube (12) including double tubes of an inner tube (1a) and an outer tube (1b) is inserted into a shell (11); and
a thermoelectric power generation module (2) inserted into between the inner tube (1a) and the outer tube (1b),
wherein the thermoelectric power generation module (2) generates thermoelectric power using a temperature difference between a first medium (14) flowing in the inner tube (1a) and a second medium (16) flowing outside the outer tube (1b) in the shell (11),
wherein the tube (12) includes a plurality of tubes inserted into the shell (11),
**characterized in that** an inner tube (1a) of each tube is fixed to the shell (11) with an inner-tube fixing tube plate (31), and an outer tube (1b) of each tube is fixed to the shell (11) with an outer-tube fixing tube plate (32), and
an output of the thermoelectric power generation module (2) is taken out through a clearance between the inner-tube fixing tube plate (31) and the outer-tube fixing tube plate (32).

2. The thermoelectric power generation system of claim 1, wherein
the first medium flowing (14) in the inner tube (1a) is coolant, and the second medium (16) flowing in the shell (11) is water vapor.

3. The thermoelectric power generation system of claim 1 or 2, wherein
the second medium (16) flowing in the shell (11) is any one selected from drainage hot water and drainage steam in geothermal power generation, continuous blow hot drainage water from a boiler, flash steam from a boiler, drainage steam from a steam turbine, and drainage hot water or drainage steam from a gas engine.

4. The thermoelectric power generation system of any one of claims 1 to 3, wherein
a heat dissipation sheet (3b) is inserted into between the thermoelectric power generation module (2) and the outer tube (1b).

5. The thermoelectric power generation system of any one of claims 1 to 4, wherein
the double tubes are seamless tubes.

## Patentansprüche

1. Thermoelektrisches Stromerzeugungssystem, umfassend:
einen Rohrbündelwärmetauscher (50), bei dem ein Rohr (12), umfassend Doppelrohre in Form eines Innenrohrs (1a) und eines Außenrohrs (1b), in einem Mantel (11) aufgenommen ist; und
ein zwischen dem Innenrohr (1a) und dem Außenrohr (1b) aufgenommenes thermoelektrisches Stromerzeugungsmodul (2),
wobei das thermoelektrische Stromerzeugungsmodul (2) mittels eines Temperaturunterschieds zwischen einem in dem Innenrohr (1a) strömenden ersten Medium (14) und einem außerhalb des Außenrohrs (1b) innerhalb des Mantels (11) strömenden zweiten Medium (16) thermoelektrischen Strom erzeugt,
wobei das Rohr (12) eine Vielzahl von in dem Mantel (11) aufgenommenen Rohren umfasst,
**dadurch gekennzeichnet, dass** ein Innenrohr (1a) jedes Rohrs mit einer Innenrohrbefestigungsrohrplatte (31) an dem Mantel (11) befestigt ist und ein Außenrohr (1b) jedes Rohrs mit einer Außenrohrbefestigungsrohrplatte (32) an dem Mantel (11) befestigt ist und
ein Ausgang des thermoelektrischen Stromerzeugungsmoduls (2) durch einen Freiraum zwischen der Innenrohrbefestigungsrohrplatte (31) und der Außenrohrbefestigungsrohrplatte (32) herausgeführt ist.

2. Thermoelektrisches Stromerzeugungssystem nach Anspruch 1, wobei
das in dem Innenrohr (1a) strömende erste Medium (14) ein Kühlmittel ist und das innerhalb des Mantels (11) strömende zweite Medium (16) Wasserdampf ist.

3. Thermoelektrisches Stromerzeugungssystem nach Anspruch 1 oder 2, wobei
es sich bei dem innerhalb des Mantels (11) strömenden zweiten Medium (16) wahlweise um heißes Abwasser oder Abdampf bei der geothermischen Stromerzeugung, heißes Abwasser aus einer kontinuierlichen Abschlammung eines Boilers, Entspannungsdampf eines Boilers, Abdampf einer Dampfturbine oder heißes Abwasser oder Abdampf eines Gasmotors handelt.

4. Thermoelektrisches Stromerzeugungssystem nach einem der Ansprüche 1 bis 3, wobei
zwischen dem thermoelektrischen Stromerzeugungsmodul (2) und dem Außenrohr (1b) ein Wärmeableitblech (3b) aufgenommen ist.

5. Thermoelektrisches Stromerzeugungssystem nach einem der Ansprüche 1 bis 4, wobei
die Doppelrohre nahtlose Rohre sind.

## Revendications

1. Système de génération d'énergie thermoélectrique comprenant :
un échangeur de chaleur à tubes (50) configuré de telle manière qu'un tube (12) comportant un double tube composé par un tube intérieur (1a) et un tube extérieur (1b) est inséré dans une calandre (11) ; et
un module de génération d'énergie thermoélectrique (2) inséré entre le tube intérieur (1a) et le tube extérieur (1b),
dans lequel le module de génération d'énergie thermoélectrique (2) génère de l'énergie thermoélectrique en utilisant une différence de température entre un premier fluide (14) s'écoulant dans le tube intérieur (1a) et un deuxième fluide (16) s'écoulant hors du tube extérieur (1b) dans la calandre (11),
dans lequel le tube (12) comporte une pluralité de tubes insérés dans la calandre (11),
**caractérisé en ce qu'**un tube intérieur (1a) de chaque tube est fixé à la calandre (11) avec une plaque de tube de fixation de tube intérieur (31), et un tube extérieur (1b) de chaque tube est fixé à la calandre (11) avec une plaque de tube de fixation de tube extérieur (32), et
une sortie du module de génération d'énergie thermoélectrique (2) est faite sortir au travers d'un espace entre la plaque de tube de fixation de tube intérieur (31) et la plaque de tube de fixation de tube extérieur (32).

2. Système de génération d'énergie thermoélectrique selon la revendication 1, dans lequel
le premier fluide (14) s'écoulant dans le tube intérieur (1a) est du fluide de refroidissement, et le deuxième fluide (16) s'écoulant dans la calandre (11) est de la vapeur d'eau.

3. Système de génération d'énergie thermoélectrique selon la revendication 1 ou 2, dans lequel
le deuxième fluide (16) s'écoulant dans la calandre (11) est l'un quelconque choisi parmi l'eau de drainage chaude et la vapeur de drainage dans la génération d'énergie géothermique, l'eau de drainage chaude de la purge continue d'une chaudière, la vapeur de revaporisation d'une chaudière, la vapeur de drainage d'une turbine à vapeur et l'eau de drainage chaude ou la vapeur de drainage d'un moteur à gaz.

4. Système de génération d'énergie thermoélectrique selon l'une quelconque des revendications 1 à 3, dans lequel
une tôle de dissipation de chaleur (3b) est insérée entre le module de génération d'énergie thermoélectrique (2) et le tube extérieur (1b).

5. Système de génération d'énergie thermoélectrique selon l'une quelconque des revendications 1 à 4, dans lequel
les doubles tubes sont des tubes sans soudure.
